(19) Europäisches Patentamt
European Patent Office
Office européen des brevets

(11) **EP 3 553 539 B1**

(12) **EUROPEAN PATENT SPECIFICATION**

(45) Date of publication and mention
of the grant of the patent:
**01.07.2020 Bulletin 2020/27**

(51) Int Cl.:
***G01R 31/50*** (2020.01)          ***G01R 31/62*** (2020.01)
***G01R 31/72*** (2020.01)

(21) Application number: **18167372.4**

(22) Date of filing: **13.04.2018**

(54) **APPARATUS AND METHOD FOR LOCATING A FAULT IN A PLURALITY OF WINDINGS OF A TRANSFORMER**

VORRICHTUNG UND VERFAHREN ZUM LOKALISIEREN EINES FEHLERS IN MEHREREN WICKLUNGEN EINES TRANSFORMATORS

APPAREIL ET PROCÉDÉ POUR LOCALISER UN DÉFAUT DANS UNE PLURALITÉ D'ENROULEMENTS D'UN TRANSFORMATEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**16.10.2019 Bulletin 2019/42**

(73) Proprietor: **General Electric Technology GmbH 5400 Baden (CH)**

(72) Inventors:
• **HA, Hengxu**
**Stafford, Staffordshire ST16 1WS (GB)**
• **MA, Xiuda**
**Stafford, Staffordshire ST16 1WS (GB)**

(74) Representative: **Brevalex**
**95, rue d'Amsterdam**
**75378 Paris Cedex 8 (FR)**

(56) References cited:
**EP-A1- 2 544 322          US-A1- 2008 300 807
US-A1- 2009 059 447          US-A1- 2012 158 325
US-A1- 2015 204 934          US-A1- 2017 030 958
US-A1- 2017 227 591**

**Description**

This invention relates to an apparatus and method for locating a fault in a plurality of windings of a transformer.

US2008300807 A1 discloses a method and system for obtaining the characteristic impedance of an electrical winding of a transformer by measuring the input and output voltages and the currents within a winding across a low frequency range, and applying transmission line properties to model the winding.

It is known to use a transformer to interconnect different voltages.

According to a first aspect of the invention, there is provided an apparatus for locating a fault in a plurality of windings of a transformer, the apparatus comprising:

a measurement device configured to measure electrical flow parameters of the transformer when the transformer is in an online mode; and

a fault location determination unit configured to determine electrical flow parameters of the windings from the measured electrical flow parameters of the transformer, wherein the fault location determination unit is configured to process the determined electrical flow parameters of the windings to determine the location of the fault in the windings.

The measurement device may include one or more measurement sensors. In the case of the measurement device including multiple measurement sensors, each measurement sensor may be configured to measure either a single electrical flow parameter or multiple electrical flow parameters of the transformer. The electrical flow parameters of the transformer include voltages and/or currents of the transformer. The electrical flow parameters of the windings include voltages and/or currents of the windings.

It will be understood that, for the purposes of this specification, the transformer in its online mode is electrically connected to an electrical network for which the transformer performs its normal function, while the transformer in its offline mode is electrically disconnected from the same electrical network.

The provision of the fault location determination unit in the apparatus of the invention enables the identification of the fault location even when the transformer remains online, i.e. electrically connected to the electrical network. This advantageously removes the need to switch the transformer into its offline mode for fault location determination purposes which would have the adverse effect of further increasing power outage time that would inconvenience end users and the electrical network operator. In addition, removing the need to switch the transformer into its offline mode for fault location determination purposes reduces the overall time taken to determine the location of the fault, and thus enables a quicker response to the fault in order to restore normal operation of the transformer.

Furthermore, the configuration of the fault location determination unit to be able to identify the fault location using the measured electrical flow parameters of the transformer permits the use of measurement sensors which are already in place to monitor the transformer, thus obviating the need to add new hardware.

The apparatus of the invention may be used with a wide range of transformers including, but not limited to, a single-phase transformer, a multi-phase transformer (e.g. a three-phase transformer), a shell-type transformer, and a core-type transformer.

The determination of the location of the fault in the windings may include determining which of the windings is the location of the fault, and preferably further includes determining which of a plurality of turns of one or more of the windings is the location of the fault. The determination of the location of the fault in the windings can be carried out in a different number of ways, examples of which are described as follows.

In embodiments of the invention, the apparatus may be configured for locating a fault in a plurality of windings of a multi-phase transformer, the fault location determination unit may be configured to determine electrical phasor values from the measured electrical flow parameters of the transformer, and the fault location determination unit may be configured to determine the electrical flow parameters of the windings from the determined electrical phasor values. Such configuration of the fault location determination unit improves the accuracy of the determination of the location of a fault in a plurality of windings of a multi-phase transformer.

The determination of the location of the fault in the windings may involve the use of a zero-sequence current differential method. For example, the fault location determination unit may be configured to determine one or more zero-sequence current values from the determined electrical flow parameters of the windings, and the fault location determination unit may be configured to compare the or each zero-sequence current value with one or more neutral current values of the windings so as to determine which of the windings is the location of the fault.

The determination of the location of the fault in the windings may involve the use of a voltage differential method. The fault location determination unit is configured to:

determine phase-comparison voltage values and phase-comparison current values by comparing the determined electrical flow parameters of the windings;

determine excitation voltage values of the windings from the determined phase-comparison voltage values and phase-comparison current values;

determine winding-comparison excitation voltage values by comparing the determined excitation voltage values of the windings; and

compare the determined winding-comparison excitation voltage values so as to determine which of the windings is the location of the fault.

For the purposes of this specification, a phase-comparison voltage is the differential between voltages of different phases, and a phase-comparison current is the differential between currents of different phases.

Also, for the purposes of this specification, a winding-comparison voltage is the differential between voltages of different windings, a winding-comparison current is the differential between currents of different windings, and a winding-comparison excitation voltage is the differential between excitation voltages of different windings.

In further embodiments of the invention in which the apparatus is configured for locating a fault in a plurality of windings of a multi-phase transformer, the fault location determination unit may be configured to determine the location of the fault based on an equivalent circuit of the multi-phase transformer which represents voltage and current conditions in the windings, impedances of the windings, transformer magnetizing impedance, and a phase to ground fault on one or more of the windings, wherein the fault location determination unit may be configured to determine the voltage and current conditions from the determined electrical flow parameters of the windings.

In still further embodiments of the invention in which the apparatus is configured for locating a fault in a plurality of windings of a multi-phase transformer, the fault location determination unit may be configured to determine the location of the fault based on an equivalent circuit of the multi-phase transformer which represents voltage and current conditions in the windings, impedances of the windings, transformer magnetizing impedance, and a phase to phase fault on one or more of the windings, wherein the fault location determination unit may be configured to determine the voltage and current conditions from the determined electrical flow parameters of the windings.

In such embodiments of the invention in which the apparatus is configured for locating a fault in a plurality of windings of a multi-phase transformer, the equivalent circuit of the multi-phase transformer may further represent transformer leakage resistance and/or transformer leakage reactance.

Optionally the apparatus of the invention may be configured for locating a fault in a pair of windings of a single-phase transformer, exemplary configurations of which are described as follows.

In a first exemplary configuration of such an apparatus, the fault location determination unit may be configured to determine the location of the fault based on an equivalent circuit of the single-phase transformer which represents voltage and current conditions in the windings, impedances of the windings, transformer magnetizing impedance, and an inter-turn fault on one or more of the windings, wherein the fault location determination unit may be configured to determine the voltage and current conditions from the determined electrical flow parameters of the windings.

In a second exemplary configuration of such an apparatus, the fault location determination unit may be configured to determine the location of the fault based on an equivalent circuit of the single-phase transformer which represents voltage and current conditions in the windings, impedances of the windings, transformer magnetizing impedance, and a winding to winding fault between the windings, wherein the fault location determination unit may be configured to determine the voltage and current conditions from the determined electrical flow parameters of the windings.

In a third exemplary configuration of such an apparatus, the fault location determination unit may be configured for locating a fault in a pair of windings of a single-phase transformer, and the fault location determination unit may be configured to determine the location of the fault based on an equivalent circuit of the single-phase transformer which represents voltage and current conditions in the windings, impedances of the windings, transformer magnetizing impedance, and a winding to ground fault in one or more of the windings, wherein the fault location determination unit may be configured to determine the voltage and current conditions from the determined electrical flow parameters of the windings.

It is envisaged that the apparatus of the invention may form part of a transformer protection equipment so that, after the location of the fault in the windings is determined, the transformer protection equipment provides the fault location to a user or operator. According to a second aspect of the invention, there is provided a method for locating a fault in a plurality of windings of a transformer, the method comprising the steps of:

measuring electrical flow parameters of the transformer when the transformer is in an online mode;

determining electrical flow parameters of the windings from the measured electrical flow parameters of the transformer; and

processing the determined electrical flow parameters of the windings to determine the location of the fault in the windings.

In the method of the invention, determining the location of the fault in the windings may include determining which of the windings is the location of the fault, and preferably further includes determining which of a plurality of turns of one or more of the windings is the location of the fault.

To locate a fault in a plurality of windings of a multi-phase transformer, the method may include the steps of determining electrical phasor values from the measured electrical flow parameters of the transformer, and determining the electrical flow parameters of the windings from the determined electrical phasor values.

The method of the invention may include the steps of determining one or more zero-sequence current values from the determined electrical flow parameters of the windings, and comparing the or each zero-sequence current value with one or more neutral current values of the windings so as to determine which of the windings is the location of the fault.

The method of the invention includes the steps of:

determine phase-comparison voltage values and phase-comparison current values by comparing the determined electrical flow parameters of the windings;

determine excitation voltage values of the windings from the determined phase-comparison voltage values and phase-comparison current values;

determine winding-comparison excitation voltage values by comparing the determined excitation voltage values of the windings; and

compare the determined winding-comparison excitation voltage values so as to determine which of the windings is the location of the fault.

To locate a fault in a plurality of windings of a multi-phase transformer, the method of the invention may include the step of determining the location of the fault based on an equivalent circuit of the multi-phase transformer which represents voltage and current conditions in the windings, impedances of the windings, transformer magnetizing impedance, and a phase to ground fault on one or more of the windings, wherein the method of the invention may include the step of determining the voltage and current conditions from the determined electrical flow parameters of the windings.

To locate a fault in a plurality of windings of a multi-phase transformer, the method of the invention may include the step of determining the location of the fault based on an equivalent circuit of the multi-phase transformer which represents voltage and current conditions in the windings, impedances of the windings, transformer magnetizing impedance, and a phase to phase fault on one or more of the windings, wherein the method of the invention may include the step of determining the voltage and current conditions from the determined electrical flow parameters of the windings.

In the method of the invention, the equivalent circuit of the multi-phase transformer may further represent transformer leakage resistance and/or transformer leakage reactance.

To locate a fault in a pair of windings of a single-phase transformer, the method of the invention may include the step of determining the location of the fault based on an equivalent circuit of the single-phase transformer which represents voltage and current conditions in the windings, impedances of the windings, transformer magnetizing impedance, and an inter-turn fault on one or more of the windings, wherein the method of the invention may include the step of determining the voltage and current conditions from the determined electrical flow parameters of the windings.

To locate a fault in a pair of windings of a single-phase transformer, the method of the invention may include the step of determining the location of the fault based on an equivalent circuit of the single-phase transformer which represents voltage and current conditions in the windings, impedances of the windings, transformer magnetizing impedance, and a winding to winding fault between the windings, wherein the method of the invention may include the step of determining the voltage and current conditions from the determined electrical flow parameters of the windings.

To locate a fault in a pair of windings of a single-phase transformer, the method of the invention may include the step of determining the location of the fault based on an equivalent circuit of the single-phase transformer which represents voltage and current conditions in the windings, impedances of the windings, transformer magnetizing impedance, and a winding to ground fault in one or more of the windings, wherein the method of the invention may include the step of determining the voltage and current conditions from the determined electrical flow parameters of the windings.

The advantages of the apparatus of the first aspect of the invention and its embodiments apply mutatis mutandis to the method of the second aspect of the invention and its embodiments.

A preferred embodiment of the invention will now be described, by way of a non-limiting example, with reference to the accompanying drawings in which:

Figure 1 shows schematically a block diagram representative of a fault location determination unit of an apparatus according to an embodiment of the invention;

Figures 2 to 7 respectively illustrate a fault location determination process using the fault location determination unit to locate a fault in the windings of a three-phase transformer;

Figures 8 and 9 illustrate a fault location determination process using the fault location determination unit to locate a position of a fault within a faulty winding;

Figure 10 shows schematically a single-phase transformer with an inter-turn fault;

Figure 11 shows schematically an equivalent circuit of the single-phase transformer of Figure 10;

Figure 12 shows schematically the single-phase transformer with a winding to winding fault;

Figure 13 shows schematically an equivalent circuit of the single-phase transformer of Figure 12;

Figure 14 shows schematically the single-phase transformer with a winding to winding to ground fault; and

Figure 15 shows schematically an equivalent circuit of the single-phase transformer of Figure 14.

In use, a transformer 20 is electrically connected to an electrical network so as to interconnect different voltages. The transformer 20 may be a single-phase or multi-phase transformer 20. The transformer 20 may be a shell-type or core-type transformer 20. During the operation of the transformer 20, a fault may occur in the windings of the transformer 20. The fault may be in the form of, for example, an inter-turn fault, a winding to ground fault, a winding to winding fault, a phase to ground fault, a phase to phase fault, or a combination thereof.

To identify the location of the fault in the windings, there is provided an apparatus according to an embodiment of the invention. The apparatus comprises a measurement device (not shown) and a fault location determination unit 22.

The measurement device includes a plurality of measurement sensors, which in this embodiment are voltage and current sensors, which are configured to measure voltages and currents at terminals of the transformer 20 under both healthy and fault conditions. In use, when the fault occurs in the windings of the transformer 20, the measurement device measures the voltages and currents at the terminals of the transformer 20 when the transformer 20 is in an online mode under the fault conditions.

The measured voltages and currents at the terminals of the transformer 20 are then provided by the measurement device to the fault location determination unit 22. The fault location determination unit 22 then determines the voltages and currents of the windings from the measured voltages and currents, and then processes the determined voltages and currents of the windings to identify the location of the fault in the windings.

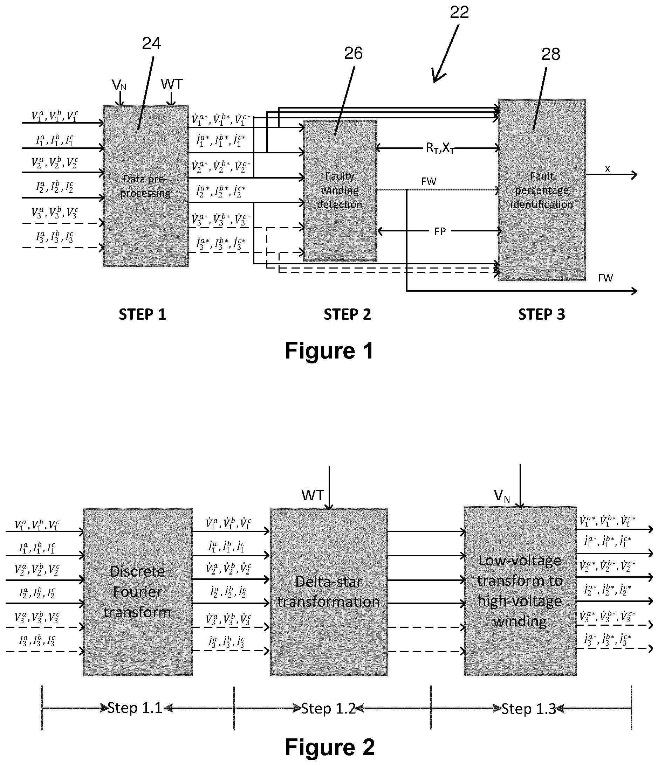

Figure 1 shows schematically a block diagram representative of the fault location determination unit 22 for locating a fault in the windings of a three-phase transformer 20, which may be a two-winding or multi-winding transformer 20.

Voltage inputs $V_i^a$, $V_i^b$ and $V_i^c$ into the fault location determination unit 22 are the measured three-phase voltages at the terminals $i$ ($i$=1, 2 or 3) of the transformer 20. Current inputs $I_i^a$, $I_i^b$ and $I_i^c$ into the fault location determination unit 22 are the measured three-phase currents at the terminals $i$ ($i$=1, 2 or 3) of the transformer 20.

A first input $V_N$ into the fault location determination unit 22 is the rated voltage at each terminal. A second input WT into the fault location determination unit 22 indicates the type of each winding, where '1' indicates a grounded star ($Y_G$) winding, '2' indicates a star (Y) winding, '3' indicates a delta (Δ) winding, so that the vector of a $Y_G$/Y/Δ transformer 20 would be [1,2,3]'. Third and fourth inputs $R_T$ and $X_T$ into the fault location determination unit 22 are transformer leakage resistance and reactance referred to the high-voltage side at each terminal, respectively. A fifth input FP into the fault location determination unit 22 indicates which of the phases is the faulty phase; if the fault occurs on a phase, the elements that present the phase are '1' or '0', for example, when a phase-to-phase fault occurs on phase A and phase B, the vector will be [1,1,0]'.

The fault location determination unit 22 is configured to generate a faulty winding indicator FW, which is selected from the numbers '1', '2', '3', to indicate which of the windings is the faulty winding, and also to generate an output x to indicate the location of the fault within the faulty winding as a percentage of the length of the faulty winding from the top end of the faulty winding.

The fault location determination unit 22 includes a first processing block 24, a second processing block 26, and a third processing block 28.

The first processing block 24 is configured to carry out a first processing step, Step 1, of the fault location determination process to determine voltages and currents of the windings. A block diagram representative of the first processing block 24 is shown in Figure 2.

Firstly, the first processing block 24 is configured to carry out a Discrete Fourier Transform (Step 1.1) of the voltage inputs $V_i^a$, $V_i^b$ and $V_i^c$ and the current inputs $I_i^a$, $I_i^b$ and If into voltage and current phasors respectively by the following equations:

$$\dot{I}_i^p(k) = \frac{2}{N}\sum_{m=0}^{N-1} I_a^p(k-m)e^{-j\frac{2\pi(k-m)}{N}}$$

$$\dot{U}_i^p(k) = \frac{2}{N}\sum_{m=0}^{N-1} U_a^p(k-m)e^{-j\frac{2\pi(k-m)}{N}}$$

Where,

$\dot{I}_i^p(k)$ and $\dot{U}_i^p(k)$ are phasor values of current and voltage, the subscript i denotes the winding, $i$=1, 2, or 3, and the subscript p denotes the phase, $p=a$, $b$ or $c$;

$N$ is the number of samples per cycle, which can be set as, for example, 8, 16, 24, 32, 48, 64, 80 or 96 depending on the platform.

Then, all voltages phasors in the delta winding undergo a delta-to-star transformation (Step 1.2) by the following equations:

For a ∆1 winding, delta-to-star transformation is made by the following equation.

$$\begin{bmatrix} \dot{V}^{a*} \\ \dot{V}^{b*} \\ \dot{V}^{c*} \end{bmatrix} = \begin{bmatrix} 1 & -1 & 0 \\ 0 & 1 & -1 \\ -1 & 0 & 1 \end{bmatrix}\begin{bmatrix} \dot{V}^a \\ \dot{V}^b \\ \dot{V}^c \end{bmatrix}$$

For a ∆11 winding, delta-to-star transformation is made by the following equation.

$$\begin{bmatrix} \dot{V}^{a*} \\ \dot{V}^{b*} \\ \dot{V}^{c*} \end{bmatrix} = \begin{bmatrix} 1 & 0 & -1 \\ -1 & 1 & 0 \\ 0 & -1 & 1 \end{bmatrix}\begin{bmatrix} \dot{V}^a \\ \dot{V}^b \\ \dot{V}^c \end{bmatrix}$$

Where,

$\dot{V}^a$, $\dot{V}^b$, and $\dot{V}^c$ are measured phase-to-ground voltage phasors;
$\dot{V}^{a*}$, $\dot{V}^{b*}$, and $\dot{V}^{c*}$ are voltages of the windings.

Voltage and current phasors referred to high-voltage winding are derived (Step 1.3) by the following equations:

$$\begin{bmatrix} \dot{V}^{a*} \\ \dot{V}^{b*} \\ \dot{V}^{c*} \end{bmatrix} = \frac{k_H U_{HN}}{k_L U_{LN}}\begin{bmatrix} \dot{V}^a \\ \dot{V}^b \\ \dot{V}^c \end{bmatrix}$$

$$\begin{bmatrix} \dot{I}^{a*} \\ \dot{I}^{b*} \\ \dot{I}^{c*} \end{bmatrix} = \frac{k_L U_{LN}}{k_H U_{HN}}\begin{bmatrix} \dot{I}^a \\ \dot{I}^b \\ \dot{I}^c \end{bmatrix}$$

Where,

$U_{HN}$ and $U_{LN}$ are rated voltages in high-voltage winding and low-voltage winding, respectively;
$k_H$ and $k_L$ are ratio correction factor, if the winding type is $Y_G$ or Y, $k_H$(or $k_L$) = 1; if the winding type is $\Delta$,

$$k_H (or\ k_L) = \sqrt{3}.$$

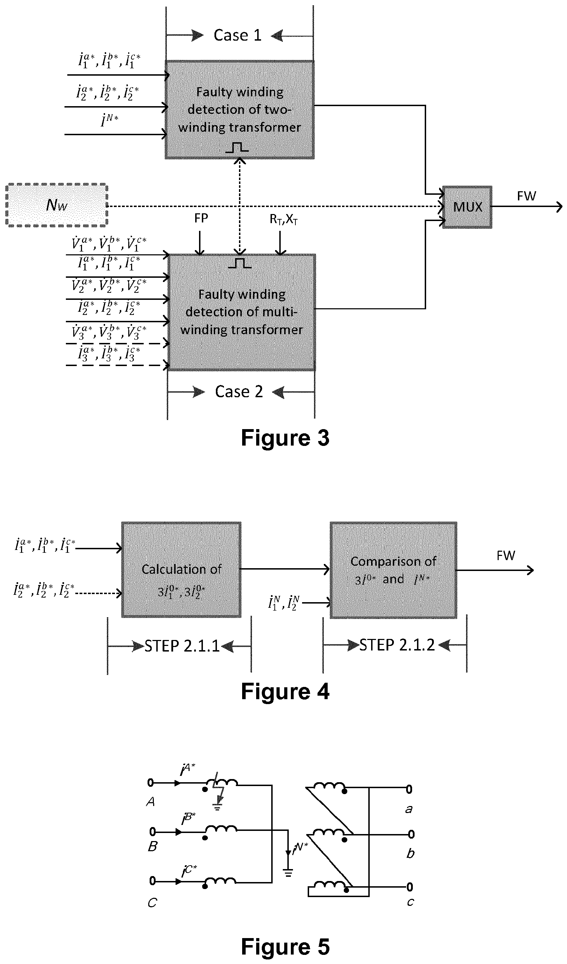

The second processing block 26 is configured to carry out a second processing step, Step 2, of the fault location determination process to identify the faulty winding. A block diagram representative of the second processing block 26 is shown in Figure 3.

The second processing block 26 is configured to perform a zero-sequence differential method to identify the faulty winding if the transformer 20 is a two-winding transformer 20 (Case 1), and a voltage differential method to identify the faulty winding if the transformer 20 is a multi-winding transformer 20 (Case 2). It is envisaged that, in other embodiments of the invention, the second processing block 26 may be configured to be capable of performing one of the two differential methods.

Figure 4 shows schematically the identification of the faulty winding using the zero-sequence differential method which uses the currents of the windings and neutral currents of the windings. The neutral point-to-ground currents $\dot{I}^{N*}$ of the windings may be obtained using measurement sensors for input into the fault location determination unit 22. For the purposes of illustrating the zero-sequence differential method, the direction references of $\dot{I}^{a*}, \dot{I}^{b*}$ and $\dot{I}^{c*}$ and $\dot{I}^{N*}$ are defined in the manner shown in Figure 5.

Firstly, the fault location determination unit 22 is configured to determine first and second zero-sequence current values $3I_1^{0*}$, $3I_2^{0*}$ for a first and a second of the two windings respectively from the currents of the windings, Step 2.1.1. If it's a $Y_G\Delta$ transformer 20, the currents of the $Y_G$ winding are used. If it's a $Y_GY_G$ transformer 20, the currents of all of the windings are used. The first and second zero-sequence current values $3I_1^{0*}$, $3I_2^{0*}$ are calculated as follows:

$$3I^{0*} = \dot{I}^{a*} + \dot{I}^{b*} + \dot{I}^{c*}$$

Where $\dot{I}^{a*}$, $\dot{I}^{b*}$ and $\dot{I}^{c*}$ are the currents of the $Y_G$ windings.

This is followed by comparing $3\dot{I}^{0*}$ and $\dot{I}^{N*}$ to detect the faulty winding of a $Y_G\Delta$ or $Y_GY_G$ transformer 20, Step 2.1.2. If it's a $Y_G\Delta$ transformer 20, a criterion is set as the following equation.

$$\begin{cases} |3I_1^{0*} - I_1^N| \geq I^{set}, FW = 1 \\ |3I_1^{0*} - I_1^N| < I^{set}, FW = 2 \end{cases}$$

Where:

$I^{set}$ is threshold setting current value;
| | is to calculate the modulus value.

If it's a $Y_GY_G$ transformer 20,

$$\begin{cases} |3I_1^{0*} - I_1^N| \geq |3I_2^{0*} - I_2^N|, FW = 1 \\ |3I_1^{0*} - I_1^N| < |3I_2^{0*} - I_2^N|, FW = 2 \end{cases}$$

Where:
| | is to calculate the modulus value.

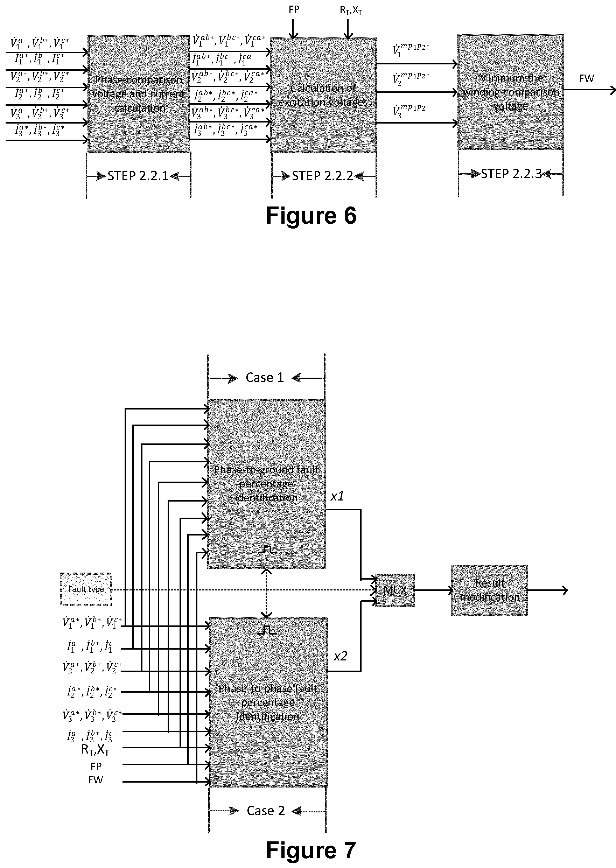

Figure 6 shows schematically the identification of the faulty winding using the voltage differential method which uses the voltages and currents of the windings.

Firstly, phase-comparison voltage values and phase-comparison current values are obtained by comparing the voltages and currents of the windings, Step 2.2.1, as follows. Phase-comparison voltages are determined using the following equations:

$$\begin{bmatrix} \dot{V}_1^{ab*} \\ \dot{V}_1^{bc*} \\ \dot{V}_1^{ca*} \end{bmatrix} = \begin{bmatrix} 1 & -1 & 0 \\ 0 & 1 & -1 \\ -1 & 0 & 1 \end{bmatrix} \begin{bmatrix} \dot{V}_1^{a*} \\ \dot{V}_1^{b*} \\ \dot{V}_1^{c*} \end{bmatrix}$$

$$\begin{bmatrix} \dot{V}_2^{ab*} \\ \dot{V}_2^{bc*} \\ \dot{V}_2^{ca*} \end{bmatrix} = \begin{bmatrix} 1 & -1 & 0 \\ 0 & 1 & -1 \\ -1 & 0 & 1 \end{bmatrix} \begin{bmatrix} \dot{V}_2^{a*} \\ \dot{V}_2^{b*} \\ \dot{V}_2^{c*} \end{bmatrix}$$

$$\begin{bmatrix} \dot{V}_3^{ab*} \\ \dot{V}_3^{bc*} \\ \dot{V}_3^{ca*} \end{bmatrix} = \begin{bmatrix} 1 & -1 & 0 \\ 0 & 1 & -1 \\ -1 & 0 & 1 \end{bmatrix} \begin{bmatrix} \dot{V}_3^{a*} \\ \dot{V}_3^{b*} \\ \dot{V}_3^{c*} \end{bmatrix}$$

Phase-comparison currents are calculated based on the winding type as follows. If the winding type is Y or $Y_G$, the equation used is:

$$\begin{bmatrix} \dot{I}_Y^{ab*} \\ \dot{I}_Y^{bc*} \\ \dot{I}_Y^{ca*} \end{bmatrix} = \begin{bmatrix} 1 & -1 & 0 \\ 0 & 1 & -1 \\ -1 & 0 & 1 \end{bmatrix} \begin{bmatrix} \dot{I}_Y^{a*} \\ \dot{I}_Y^{b*} \\ \dot{I}_Y^{c*} \end{bmatrix}$$

If the winding type is Δ1, the equation used is:

$$\begin{bmatrix} \dot{I}_\Delta^{ab*} \\ \dot{I}_\Delta^{bc*} \\ \dot{I}_\Delta^{ca*} \end{bmatrix} = \begin{bmatrix} 1 & 0 & 1 \\ 1 & 1 & 0 \\ 0 & 1 & 1 \end{bmatrix} \begin{bmatrix} \dot{I}_\Delta^{a*} \\ \dot{I}_\Delta^{b*} \\ \dot{I}_\Delta^{c*} \end{bmatrix}$$

If the winding type is Δ11, the equation used is:

$$\begin{bmatrix} \dot{I}_\Delta^{ab*} \\ \dot{I}_\Delta^{bc*} \\ \dot{I}_\Delta^{ca*} \end{bmatrix} = \begin{bmatrix} 1 & 0 & 0 \\ 0 & 1 & 0 \\ 0 & 0 & 1 \end{bmatrix} \begin{bmatrix} \dot{I}_\Delta^{a*} \\ \dot{I}_\Delta^{b*} \\ \dot{I}_\Delta^{c*} \end{bmatrix}$$

Then excitation voltage values of the windings are determined from the determined phase-comparison voltage values and phase-comparison current values, Step 2.2.2, using the following equation:

$$\begin{bmatrix} \dot{V}_1^{mp_1p_2*} \\ \dot{V}_2^{mp_1p_2*} \\ \dot{V}_3^{mp_1p_2*} \end{bmatrix} = \begin{bmatrix} \dot{V}_1^{p_1p_2*} \\ \dot{V}_2^{p_1p_2*} \\ \dot{V}_3^{p_1p_2*} \end{bmatrix} - \begin{bmatrix} R_1 + j\omega L_1 & 0 & 0 \\ 0 & R_2 + j\omega L_2 & 0 \\ 0 & 0 & R_3 + j\omega L_3 \end{bmatrix} \begin{bmatrix} \dot{I}_1^{p_1p_2*} \\ \dot{I}_2^{p_1p_2*} \\ \dot{I}_3^{p_1p_2*} \end{bmatrix}$$

Where:

the subscripts $p_1$, and $p_2$ denote two phases, if phase-to-phase fault occurs, these two phases are faulty phases; if phase-to-ground fault occurs, one is faulty phase, the other is normal phase;
the subscript m denotes the excitation;
R and L are leakage resistance and inductance which are referred to high-voltage winding.

This is followed by determining the winding-comparison excitation voltage values by the following equations:

$$\begin{bmatrix} \dot{V}_{12}^{mp_1p_2*} \\ \dot{V}_{23}^{mp_1p_2*} \\ \dot{V}_{31}^{mp_1p_2*} \end{bmatrix} = \begin{bmatrix} \dot{V}_{1}^{mp_1p_2*} \\ \dot{V}_{2}^{mp_1p_2*} \\ \dot{V}_{3}^{mp_1p_2*} \end{bmatrix} - \begin{bmatrix} \dot{V}_{2}^{mp_1p_2*} \\ \dot{V}_{3}^{mp_1p_2*} \\ \dot{V}_{1}^{mp_1p_2*} \end{bmatrix}$$

Finally, the determined winding-comparison excitation voltage values are compared, Step 2.2.3, so as to determine which of the windings is the location of the fault.

If $\dot{V}_{12}^{mp_1p_2*} = \min(\dot{V}_{12}^{mp_1p_2*}, \dot{V}_{23}^{mp_1p_2*}, \dot{V}_{31}^{mp_1p_2*}),$ then the faulty winding is 3.

If $\dot{V}_{23}^{mp_1p_2*} = \min(\dot{V}_{12}^{mp_1p_2*}, \dot{V}_{23}^{mp_1p_2*}, \dot{V}_{31}^{mp_1p_2*}),$ then the faulty winding is 1.

If $\dot{V}_{31}^{mp_1p_2*} = \min(\dot{V}_{12}^{mp_1p_2*}, \dot{V}_{23}^{mp_1p_2*}, \dot{V}_{31}^{mp_1p_2*}),$ then the faulty winding is 2;

The third processing block 28 is configured to carry out a third processing step, Step 3, of the fault location determination process to identify the location of the fault within the faulty winding. A block diagram representative of the third processing block 28 is shown in Figure 7.

The third processing block 28 is configured to determine the location of the fault based on an equivalent circuit of the three-phase transformer 20 which represents voltage and current conditions in the windings, impedances of the windings, transformer magnetizing impedance, transformer leakage resistance, and transformer leakage reactance. The equivalent circuit further represents a phase to ground fault on the faulty winding (Case 1), or a phase to phase fault on the faulty winding (Case 2). The voltage and current conditions can be determined from the voltages and currents of the windings.

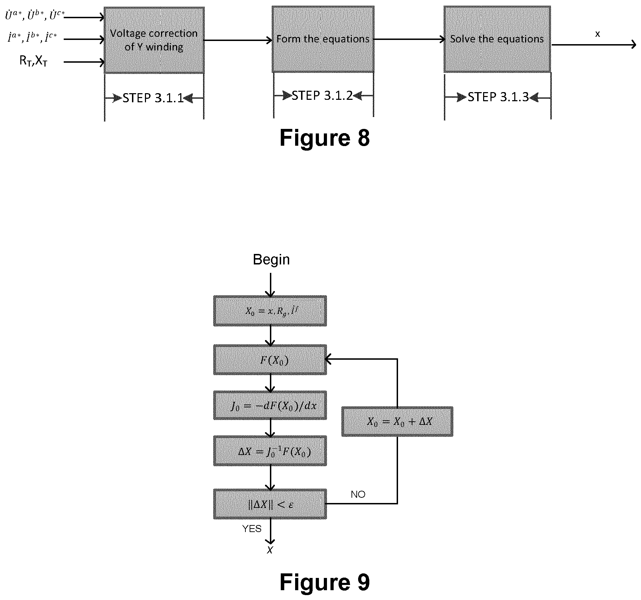

Figures 8 and 9 illustrate the determination of the location of the fault within the faulty winding in the event of a phase to ground fault on the faulty winding.

If the phase-to-ground fault occurs on a Y winding, the three-phase voltages of the faulty winding are corrected, Step 3.1.1. If phase p is faulty phase, the correction is carried out so that $\dot{V}^{p**} = \dot{V}^{p*}$. If not, the correction is carried out so that $\dot{V}^{p**} = V^{p*} - \dot{V}^N$, where $\dot{V}^N$ is the neutral point to ground voltage as calculated by the following equation:

$$\dot{V}^N = \dot{V}_1^{p*} - \dot{I}_1^{p*}(R_1 + j\omega L_1) - [\dot{V}_2^{p*} - \dot{I}_2^{p*}(R_2 + j\omega L_2)]$$

If the phase-to-ground fault occurs on phase p (p=a, b, c), winding w (w=1, 2, 3), equations are established, Step 3.1.2, as shown below.

$$\begin{cases} \dfrac{\left(V_w^{p*} - R^g\left(i_w^{p*} - i^f\right)\right)}{x} = (R_w + j\omega L_w)i_w^{p*} + j(\omega L_m + \omega L_s)\left[xi_w^{p*} + (1-x)i^f + \sum_{k \in W} i_k^{p*}\right] \\ \\ \quad +j\omega L_m\left(\sum_{k \in W} i_k^{p+1*} + \sum_{w \in W} i_k^{p+2*}\right)(1-x)i^f + \sum_{k \in W} i_k^{p*} - \sum_{k \in W} i_k^{p+1*} \end{cases}$$

$$= \frac{\dot{V}_w^{p*} - \dot{V}_w^{p+1*} - (R_w + j\omega L_w)(\dot{I}_w^{p*} - \dot{I}_w^{p+1*})}{j\omega L_s}$$

Where,

x is the fault location percentage from the top of the faulty winding;

$R^g$ is the fault resistance;

$i^f$ is fault current from the winding to ground;

$L_m$ is magnetizing impedance, which can be calculated from the nameplate value $I_0$%;

$L_s$ is related to the number of limbs of the transformer 20, $L_s = -(N_{limb} - 1)L_m$;

the subscripts p, p+1 and p+2 denote the fault, 2nd and 3rd phase; subscripts w, w+1 and w+2 denote the fault, 2nd

winding and 3rd winding;
*W* is the set of all windings.

The equations are solved by using the Newton-Raphson method, Step 3.1.3, as illustrated in Figure 9 and as follows:

1) Give the initial value $X_0$;
2) Calculate the $F(X_0)$ at the initial value;
3) Jacobi Matrix at X0, $J_0 = -dF(X_0)/dX_0$;
4) Calculate the correction value, $\Delta X = J_0^{-1} F(X_0)$;
5) Modify the $X_0 = X_0 + \Delta X$, until $\Delta X$ satisfy the requirement.

If the phase-to-phase fault occurs on Y or $Y_G$ winding, the value of x is given by:

$$\frac{\dot{U}_w^{p*} - \dot{U}_w^{p+1*}}{(R_w + j\omega L_w)(\dot{I}_w^{p*} - \dot{I}_w^{p+1*}) + [\dot{U}_{w+1}^{p*} - (R_{w+1} + j\omega L_{w+1})\dot{I}_{w+1}^{p*}]}$$

$$-[\dot{U}_{w+1}^{p+1*} - (R_{w+1} + j\omega L_{w+1})\dot{I}_{w+1}^{p+1*}]$$

Where,

the subscripts p, p+1 and p+2 denote the fault, 2nd and 3rd phase;
subscripts w, w+1 and w+2 denote the fault, 2nd winding and 3rd winding.

If the fault occurs on Δ1 winding, the value of x is given by:

$$\frac{\dot{U}_w^{p*} - \dot{U}_w^{p+1*}}{(R_w + j\omega L_w)(\dot{I}_w^{p'} - \dot{I}_w^{p+1'}) + [\dot{U}_{w+1}^{p*} - (R_{w+1} + j\omega L_{w+1})\dot{I}_{w+1}^{p*}]}$$

$$-[\dot{U}_{w+1}^{p+1*} - (R_{w+1} + j\omega L_{w+1})\dot{I}_{w+1}^{p+1*}]$$

$$\dot{I}_w^{p'} - \dot{I}_w^{p+1'} = \dot{I}_w^{p*} - \dot{I}_w^{p+1*} - \dot{I}_w^{p+2*} + 3\frac{\dot{U}_w^{p+2*} - [\dot{U}_{w+1}^{p+2*} - (R_{w+1} + j\omega L_{w+1})\dot{I}_{w+1}^{p+2*}]}{R_w + j\omega L_w}$$

subscripts w, w+1 and w+2 denote the fault, 2nd winding and 3rd winding.
If the fault occurs on Δ1 winding, the value of x is given by:

$$\frac{\dot{U}_w^{p*} - \dot{U}_w^{p+1*}}{(R_w + j\omega L_w)(\dot{I}_w^{p'} - \dot{I}_w^{p+1'}) + [\dot{U}_{w+1}^{p*} - (R_{w+1} + j\omega L_{w+1})\dot{I}_{w+1}^{p*}]}$$

$$-[\dot{U}_{w+1}^{p+1*} - (R_{w+1} + j\omega L_{w+1})\dot{I}_{w+1}^{p+1*}]$$

$$\dot{I}_w^{p'} - \dot{I}_w^{p+1'} = \dot{I}_w^{p*} - \dot{I}_w^{p+1*} + \dot{I}_w^{p+2*} - 3\frac{\dot{U}_w^{p+2*} - [\dot{U}_{w+1}^{p+2*} - (R_{w+1} + j\omega L_{w+1})\dot{I}_{w+1}^{p+2*}]}{R_w + j\omega L_w}$$

Where,

the subscripts p, p+1 and p+2 denote the fault, 2nd and 3rd phase;

subscripts w, w+1 and w+2 denote the fault, 2nd winding and 3rd winding. $\dot{i}_w^{p\prime}$ and $\dot{i}_w^{p+1\prime}$ are winding current of phase p and p+1, they are cannot be measured directly.

The fault location determination unit 22 is therefore capable of locating a fault in a plurality of windings of a three-phase transformer 20 by using voltages and currents measured at the terminals of the transformer 20 when the transformer 20 is in an online mode under the fault conditions.

It will be appreciated that the foregoing fault location determination process applies mutatis mutandis to a fault location determination process for locating a fault in a plurality of windings of a transformer 20 with a different number of multiple phases.

Optionally the fault location determination unit 22 may be configured for locating a fault in a pair of windings of a single-phase transformer 20. More particularly, such a fault location determination unit 22 is configured to determine the location of the fault based on an equivalent circuit of the single-phase transformer 20 which represents voltage and current conditions in the windings, impedances of the windings, and transformer 20 magnetizing impedance. The equivalent circuit further represents an inter-turn fault on one of the windings, a winding to winding fault, or a winding to winding to ground fault. The voltage and current conditions can be determined from the voltages and currents of the windings.

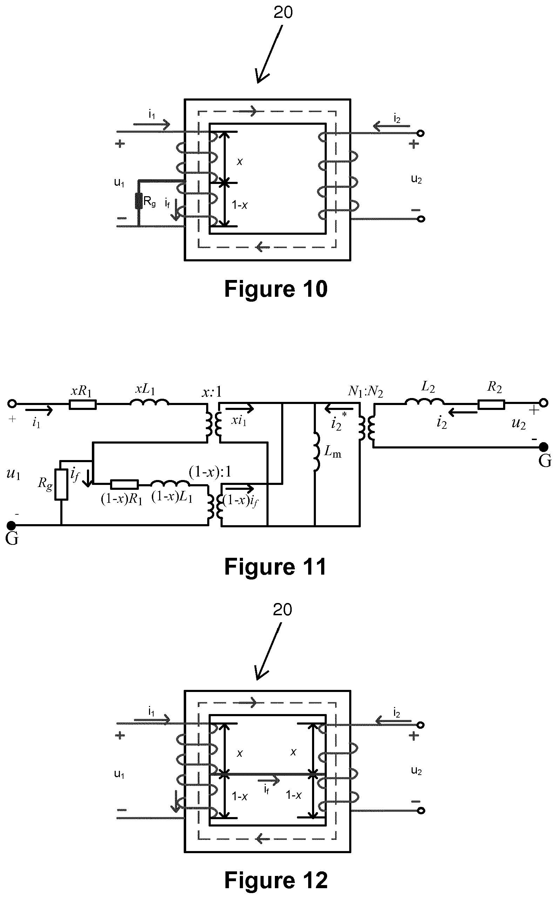

Figure 10 shows schematically the single-phase transformer 20 with the inter-turn fault on one of its windings, where the inter-turn fault is a winding to ground fault with a fault resistance $R_g$. The location of the inter-turn fault within the faulty winding corresponds to a fraction x of the length of the faulty winding from the top end of the faulty winding.

Figure 11 shows the equivalent circuit of the single-phase transformer 20 of Figure 10. The equivalent circuit in Figure 11 is given by the following equation:

$$
\begin{bmatrix} \dfrac{\dot{U}_1 - R_g\left(\dot{i}_1 - \dot{i}_f\right)}{x} \\ \dfrac{R_g\left(\dot{i}_1 - \dot{i}_f\right)}{x} \\ \dot{U}_2^* \end{bmatrix}
=
\begin{bmatrix} R_1 + j\omega L_1 & 0 & 0 \\ 0 & R_1 + j\omega L_1 & 0 \\ 0 & 0 & R_2^* + j\omega L_2^* \end{bmatrix}
\begin{bmatrix} \dot{i}_1 \\ \dot{i}_f \\ \dot{i}_2^* \end{bmatrix}
$$

$$
+ j\omega
\begin{bmatrix} L_m & L_m & L_m \\ L_m & L_m & L_m \\ L_m & L_m & L_m \end{bmatrix}
\begin{bmatrix} x\dot{i}_1 \\ (1-x)\dot{i}_f \\ \dot{i}_2^* \end{bmatrix}
$$

Where $\dot{U}_2^*$ and $\dot{i}_2^*$ are voltage and current referred to the primary winding, $\dot{U}_2^* = (N_1/N_2)\dot{U}_2, \dot{i}_2^* = (N_2/N_1)\dot{i}_2$; $R_2^*$ and $L_2^*$ are resistance and inductance referred to the primary winding, $R_2^* = (N_1/N_2)^2 R_2, L_2^* = (N_1/N_2)^2 L_2$.

The voltages $U_1$, $U_2$ and currents $I_1$, $I_2$ of the windings are calculated from the measured voltages and currents at the terminals of the single-phase transformer 20. The above equation can be solved to obtain the values of the variables x, $R_g$ and $i_f$, where $i_f$ is the fault current in the winding to ground fault.

Figure 12 shows schematically the single-phase transformer 20 with the winding to winding fault. The location of the winding to winding fault corresponds to a fraction x of the length of each winding from the top end of each winding.

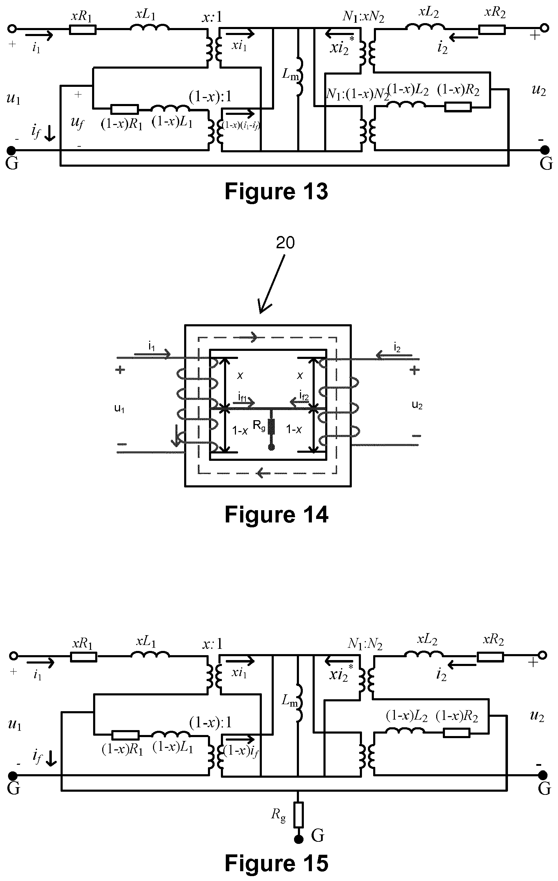

Figure 13 shows the equivalent circuit of the single-phase transformer 20 of Figure 12. The equivalent circuit in Figure 13 is given by the following equation:

$$\begin{bmatrix} \dfrac{\dot{U}_1 - \dot{U}_f}{x} \\[2mm] \dfrac{\dot{U}_f}{1-x} \\[2mm] \dfrac{\dot{U}_2^* - \dot{U}_f^*}{x} \end{bmatrix} = \begin{bmatrix} R_1 + j\omega L_1 & 0 & 0 \\ 0 & R_1 + j\omega L_1 & 0 \\ 0 & 0 & R_2^* + j\omega L_2^* \end{bmatrix} \begin{bmatrix} \dot{I}_1 \\ \dot{I}_1 - \dot{I}_f \\ \dot{I}_2^* \end{bmatrix}$$

$$+ j\omega \begin{bmatrix} L_m & L_m & L_m \\ L_m & L_m & L_m \\ L_m & L_m & L_m \end{bmatrix} \begin{bmatrix} x\dot{I}_1 \\ (1-x)(\dot{I}_1 - \dot{I}_f) \\ x\dot{I}_2^* \end{bmatrix}$$

Where,

$\dot{U}_2^*$ and $\dot{I}_2^*$ are secondary winding voltage and current referred to primary winding: $\dot{U}_2^* = (N_1/N_2)\dot{U}_2, \dot{I}_2^* = (N_2/N_1)\dot{I}_2$;

$R_2^*$ and $L_2^*$ are secondary winding resistance and inductance referred to primary

$\dot{U}_f^*$ is fault voltage referred into primary winding, $\dot{U}_f^* = (N_1/N_2)\dot{U}_f$.

Again, the voltages $U_1$, $U_2$ and currents $I_1$, $I_2$ of the windings are calculated from the measured voltages and currents at the terminals of the single-phase transformer 20. The above equation can be solved to obtain the values of the variables x" $i_f$ and $U_f$. In this case the fault current $i_f$ flows between the two windings.
Figure 14 shows schematically the single-phase transformer 20 with the winding to winding to ground fault. The location of the winding to winding to ground fault corresponds to a fraction x of the length of each winding from the top end of each winding.
Figure 15 shows the equivalent circuit of the single-phase transformer 20 of Figure 14. The equivalent circuit in Figure 13 is given by the following equation:

$$\begin{bmatrix} \dfrac{\dot{U}_1 - \dot{U}_f}{x} \\[2mm] \dfrac{\dot{U}_f}{1-x} \\[2mm] \dfrac{\dot{U}_2^* - \dot{U}_f^*}{x} \end{bmatrix} = \begin{bmatrix} R_1 + j\omega L_1 & 0 & 0 \\ 0 & R_1 + j\omega L_1 & 0 \\ 0 & 0 & R_2^* + j\omega L_2^* \end{bmatrix} \begin{bmatrix} \dot{I}_1 \\ \dot{I}_1 - \dot{I}_{f1} \\ \dot{I}_2^* \end{bmatrix}$$

$$+ j\omega \begin{bmatrix} L_m & L_m & L_m \\ L_m & L_m & L_m \\ L_m & L_m & L_m \end{bmatrix} \begin{bmatrix} x\dot{I}_1 \\ (1-x)\dot{I}_1 - \dot{I}_{f1} \\ x\dot{I}_2^* \end{bmatrix}$$

Again, the voltages $U_1$, $U_2$ and currents $I_1$, $I_2$ of the windings are calculated from the measured voltages and currents at the terminals of the single-phase transformer 20. The above equation can be solved to obtain the values of the variables x,, $i_{f1}$, $i_{f2}$ and $U_f$. In this case each of the fault currents $i_{f1}$, $i_{f2}$ flow to ground from each of the primary and secondary windings respectively.
The fault location determination unit 22 is therefore capable of locating a fault in a plurality of windings of a single-phase transformer 20 by using voltages and currents measured at the terminals of the transformer 20 when the transformer 20 is in an online mode under the fault conditions. Such a fault may include, for example, a pre-empt fault which is an initial intermittent high impedance short circuit fault preceding a severe short circuit fault
The fault location determination unit 22 may be in the form of a computing device and the like, and may include one or more features of a computing device, such as processor, memory, display device.
It will be appreciated that the above equations are intended to help illustrate the working of the invention, and are not intended to be limiting on the scope of the invention.

It will also be appreciated that the invention is exemplarily described above with reference to the use of measured voltages and currents at three terminals of the transformer 20, and the invention applies mutatis mutandis to measured voltages and currents at more than three terminals of the transformer 20, such as four or five terminals of the transformer 20.

## Claims

1. An apparatus for locating a fault in a plurality of windings of a transformer (20), the apparatus comprising:

   a measurement device configured to measure electrical flow parameters of the transformer (20) when the transformer (20) is in an online mode; and
   a fault location determination unit (22) configured to determine electrical flow parameters of the windings from the measured electrical flow parameters of the transformer (20), wherein the fault location determination unit (22) is configured to process the determined electrical flow parameters of the windings to determine the location of the fault in the windings, **characterised in that** the fault location determination unit (22) is configured to:

   determine phase-comparison voltage values and phase-comparison current values by comparing the determined electrical flow parameters of the windings;
   determine excitation voltage values of the windings from the determined phase-comparison voltage values and phase-comparison current values;
   determine winding-comparison excitation voltage values by comparing the determined excitation voltage values of the windings; and
   compare the determined winding-comparison excitation voltage values so as to determine which of the windings is the location of the fault.

2. An apparatus according to Claim 1 wherein determining the location of the fault in the windings includes determining which of the windings is the location of the fault.

3. An apparatus according to Claim 2 wherein determining the location of the fault in the windings further includes determining which of a plurality of turns of one or more of the windings is the location of the fault.

4. An apparatus according to any one of the preceding claims wherein the apparatus is configured for locating a fault in a plurality of windings of a multi-phase transformer (20), the fault location determination unit (22) is configured to determine electrical phasor values from the measured electrical flow parameters of the transformer (20), and the fault location determination unit (22) is configured to determine the electrical flow parameters of the windings from the determined electrical phasor values.

5. An apparatus according to any one of the preceding claims wherein the fault location determination unit (22) is configured to determine one or more zero-sequence current values from the determined electrical flow parameters of the windings, and the fault location determination unit (22) is configured to compare the or each zero-sequence current value with one or more neutral current values of the windings so as to determine which of the windings is the location of the fault.

6. An apparatus according to any one of the preceding claims wherein the apparatus is configured for locating a fault in a plurality of windings of a multi-phase transformer (20), and the fault location determination unit (22) is configured to determine the location of the fault based on an equivalent circuit of the multi-phase transformer (20) which represents voltage and current conditions in the windings, impedances of the windings, transformer magnetizing impedance, and a phase to ground fault on one or more of the windings, wherein the fault location determination unit (22) is configured to determine the voltage and current conditions from the determined electrical flow parameters of the windings.

7. An apparatus according to any one of the preceding claims wherein the apparatus is configured for locating a fault in a plurality of windings of a multi-phase transformer (20), and the fault location determination unit (22) is configured to determine the location of the fault based on an equivalent circuit of the multi-phase transformer (20) which represents voltage and current conditions in the windings, impedances of the windings, transformer magnetizing impedance, and a phase to phase fault on one or more of the windings, wherein the fault location determination unit (22) is configured to determine the voltage and current conditions from the determined electrical flow parameters of the windings.

8. An apparatus according to Claim 7 or Claim 8 wherein the equivalent circuit of the multi-phase transformer (20) further represents transformer leakage resistance and/or transformer leakage reactance.

9. An apparatus according to any one of the preceding claims wherein the apparatus is configured for locating a fault in a pair of windings of a single-phase transformer (20), and the fault location determination unit (22) is configured to determine the location of the fault based on an equivalent circuit of the single-phase transformer (20) which represents voltage and current conditions in the windings, impedances of the windings, transformer magnetizing impedance, and an inter-turn fault on one or more of the windings, wherein the fault location determination unit (22) is configured to determine the voltage and current conditions from the determined electrical flow parameters of the windings.

10. An apparatus according to any one of the preceding claims wherein the apparatus is configured for locating a fault in a pair of windings of a single-phase transformer (20), and the fault location determination unit (22) is configured to determine the location of the fault based on an equivalent circuit of the single-phase transformer (20) which represents voltage and current conditions in the windings, impedances of the windings, transformer magnetizing impedance, and a winding to winding fault between the windings, wherein the fault location determination unit (22) is configured to determine the voltage and current conditions from the determined electrical flow parameters of the windings.

11. An apparatus according to any one of the preceding claims wherein the apparatus is configured for locating a fault in a pair of windings of a single-phase transformer (20), and the fault location determination unit (22) is configured to determine the location of the fault based on an equivalent circuit of the single-phase transformer (20) which represents voltage and current conditions in the windings, impedances of the windings, transformer magnetizing impedance, and a winding to ground fault in one or more of the windings, wherein the fault location determination unit (22) is configured to determine the voltage and current conditions from the determined electrical flow parameters of the windings.

12. A method of locating a fault in a plurality of windings of a transformer (20), the method comprising the steps of:

measuring electrical flow parameters of the transformer (20) when the transformer (20) is in an online mode;
determining electrical flow parameters of the windings from the measured electrical flow parameters of the transformer (20); and
processing the determined electrical flow parameters of the windings to determine the location of the fault in the windings,
the method further **characterised by**:

- determining phase-comparison voltage values and phase-comparison current values by comparing the determined electrical flow parameters of the windings;
- determining excitation voltage values of the windings from the determined phase-comparison voltage values and phase-comparison current values;
- determining winding-comparison excitation voltage values by comparing the determined excitation voltage values of the windings; and

comparing the determined winding-comparison excitation voltage values so as to determine which of the windings is the location of the fault.

13. A method according to Claim 12 wherein determining the location of the fault in the windings includes determining which of the windings is the location of the fault.

14. A method according to Claim 13 wherein determining the location of the fault in the windings further includes determining which of a plurality of turns of one or more of the windings is the location of the fault.

**Patentansprüche**

1. Einrichtung zur Lokalisierung einer Störung in einer Vielzahl von Wicklungen eines Transformators (20), wobei die Einrichtung umfasst:

eine Messvorrichtung, die konfiguriert ist, elektrische Flussparameter des Transformators (20) zu messen, wenn der Transformator (20) in einem Online-Modus ist; und

eine Störungsstellenermittlungseinheit (22), die konfiguriert ist, elektrische Flussparameter der Wicklungen von den gemessenen elektrischen Flussparametern des Transformators (20) zu ermitteln, wobei die Störungsstellenermittlungseinheit (22) konfiguriert ist, die ermittelten elektrischen Flussparameter der Wicklungen zu verarbeiten, um die Stelle der Störung in den Wicklungen zu ermitteln, **dadurch gekennzeichnet, dass** die Störungsstellenermittlungseinheit (22) konfiguriert ist zum:

Ermitteln von Phasenvergleichsspannungswerten und Phasenvergleichsstromwerten, indem die ermittelten elektrischen Flussparameter der Wicklungen verglichen werden;

Ermitteln von Anregungsspannungswerten der Wicklungen aus den ermitteln Phasenvergleichsspannungswerten und Phasenvergleichsstromwerten;

Ermitteln von Wicklungsvergleichsanregungsspannungswerten, indem die ermittelten Anregungsspannungswerte der Wicklungen verglichen werden; und

Vergleichen der ermittelten Wicklungsvergleichsanregungsspannungswerte um zu ermitteln, welche der Wicklungen die Stelle der Störung ist.

2. Einrichtung nach Anspruch 1, wobei Ermitteln der Stelle der Störung in den Wicklungen Ermitteln beinhaltet, welche der Wicklungen die Stelle der Störung ist.

3. Einrichtung nach Anspruch 2, wobei Ermitteln der Stelle der Störung in den Wicklungen weiter Ermitteln beinhaltet, welche einer Vielzahl von Windungen von einer oder mehreren der Wicklungen die Stelle der Störung ist.

4. Einrichtung nach einem der vorstehenden Ansprüche, wobei die Einrichtung konfiguriert ist, eine Störung in einer Vielzahl von Wicklungen eines Mehrphasentransformators (20) zu lokalisieren, die Störungsstellenermittlungseinheit (22) konfiguriert ist, elektrische Phasorwerte aus den gemessenen elektrischen Flussparametern des Transformators (20) zu ermitteln und die Störungsstellenermittlungseinheit (22) konfiguriert ist, die elektrischen Flussparameter der Wicklungen aus den ermittelten elektrischen Phasorwerten zu ermitteln.

5. Einrichtung nach einem der vorstehenden Ansprüche, wobei die Störungsstellenermittlungseinheit (22) konfiguriert ist, einen oder mehrere Nullsequenzstromwerte aus den ermittelten elektrischen Flussparametern der Wicklungen zu ermitteln und die Störungsstellenermittlungseinheit (22) konfiguriert ist, den oder jeden Nullsequenzstromwert mit einem oder mehreren neutralen Stromwerten der Wicklungen zu vergleichen, um zu ermitteln, welche der Wicklungen die Stelle der Störung ist.

6. Einrichtung nach einem der vorstehenden Ansprüche, wobei die Einrichtung zur Lokalisierung einer Störung in einer Vielzahl von Wicklungen eines Mehrphasentransformators (20) konfiguriert ist und die Störungsstellenermittlungseinheit (22) konfiguriert ist, die Stelle der Störung basierend auf einer äquivalenten Schaltung des Mehrphasentransformators (20) zu ermitteln, die Spannungs- und Stromzustände in den Wicklungen, Impedanzen der Wicklungen, Transformatormagnetisierungsimpedanz und eine Phase-zu-Masse-Störung an einer oder mehreren der Wicklungen darstellt, wobei die Störungsstellenermittlungseinheit (22) konfiguriert ist, die Spannungs- und Stromzustände aus den ermittelten elektrischen Flussparametern der Wicklungen zu ermitteln.

7. Einrichtung nach einem der vorstehenden Ansprüche, wobei die Einrichtung zur Lokalisierung einer Störung in einer Vielzahl von Wicklungen eines Mehrphasentransformators (20) konfiguriert ist und die Störungsstellenermittlungseinheit (22) konfiguriert ist, die Stelle der Störung basierend auf einer äquivalenten Schaltung des Mehrphasentransformators (20) zu ermitteln, die Spannungs- und Stromzustände in den Wicklungen, Impedanzen der Wicklungen, Transformatormagnetisierungsimpedanz und eine Phase-zu-Phase-Störung an einer oder mehreren der Wicklungen darstellt, wobei die Störungsstellenermittlungseinheit (22) konfiguriert ist, die Spannungs- und Stromzustände aus den ermittelten elektrischen Flussparametern der Wicklungen zu ermitteln.

8. Einrichtung nach Anspruch 7 oder Anspruch 8, wobei die Ersatzschaltung des Mehrphasentransformators (20) weiter Transformatorableitwiderstand und/oder Transformatorableitreaktanz darstellt.

9. Einrichtung nach einem der vorstehenden Ansprüche, wobei die Einrichtung zur Lokalisierung einer Störung in einem Paar von Wicklungen eines Einzelphasentransformators (20) konfiguriert ist und die Störungsstellenermittlungseinheit (22) konfiguriert ist, die Stelle der Störung basierend auf einer äquivalenten Schaltung des Einzelphasentransformators (20) zu ermitteln, die Spannungs- und Stromzustände in den Wicklungen, Impedanzen der Wicklungen, Transformatormagnetisierungsimpedanz und eine Zwischenwindungsstörung an einer oder mehreren der Wicklungen darstellt, wobei die Störungsstellenermittlungseinheit (22) konfiguriert ist, die Spannungs- und Stromzustände aus den ermittelten elektrischen Flussparametern der Wicklungen zu ermitteln.

10. Einrichtung nach einem der vorstehenden Ansprüche, wobei die Einrichtung zur Lokalisierung einer Störung in einem Paar von Wicklungen eines Einzelphasentransformators (20) konfiguriert ist und die Störungsstellenermittlungseinheit (22) konfiguriert ist, die Stelle der Störung basierend auf einer äquivalenten Schaltung des Einzelphasentransformators (20) zu ermitteln, die Spannungs- und Stromzustände in den Wicklungen, Impedanzen der Wicklungen, Transformatormagnetisierungsimpedanz und eine Wicklung-zu-Wicklung-Störung zwischen den Wicklungen darstellt, wobei die Störungsstellenermittlungseinheit (22) konfiguriert ist, die Spannungs- und Stromzustände aus den ermittelten elektrischen Flussparametern der Wicklungen zu ermitteln.

11. Einrichtung nach einem der vorstehenden Ansprüche, wobei die Einrichtung zur Lokalisierung einer Störung in einem Paar von Wicklungen eines Einzelphasentransformators (20) konfiguriert ist und die Störungsstellenermittlungseinheit (22) konfiguriert ist, die Stelle der Störung basierend auf einer äquivalenten Schaltung des Einzelphasentransformators (20) zu ermitteln, die Spannungs- und Stromzustände in den Wicklungen, Impedanzen der Wicklungen, Transformatormagnetisierungsimpedanz und eine Wicklung-zu-Masse-Störung in einer oder mehreren der Wicklungen darstellt, wobei die Störungsstellenermittlungseinheit (22) konfiguriert ist, die Spannungs- und Stromzustände aus den ermittelten elektrischen Flussparametern der Wicklungen zu ermitteln.

12. Verfahren zur Lokalisierung einer Störung in einer Vielzahl von Wicklungen eines Transformators (20), wobei das Verfahren die Schritte umfasst:

Messen von elektrischen Flussparametern des Transformators (20), wenn der Transformator (20) in einem Online-Modus ist;
Ermitteln elektrischer Flussparameter der Wicklungen aus den gemessenen elektrischen Flussparametern des Transformators (20); und
Verarbeiten der ermittelten elektrischen Flussparameter der Wicklungen, um die Stelle der Störung in den Wicklungen zu ermitteln,
das Verfahren weiter **gekennzeichnet durch**:

- Ermitteln von Phasenvergleichsspannungswerten und Phasenvergleichsstromwerten, indem die ermittelten elektrischen Flussparameter der Wicklungen verglichen werden;
- Ermitteln von Anregungsspannungswerten der Wicklungen aus den ermittelten Phasenvergleichsspannungswerten und Phasenvergleichsstromwerten;
- Ermitteln von Wicklungsvergleichsanregungsspannungswerten, indem die ermittelten Anregungsspannungswerte der Wicklungen verglichen werden; und

Vergleichen der ermittelten Wicklungsvergleichsanregungsspannungswerte, um zu ermitteln, welche der Wicklungen die Stelle der Störung ist.

13. Verfahren nach Anspruch 12, wobei Ermitteln der Stelle der Störung in den Wicklungen Ermitteln beinhaltet, welche der Wicklungen die Stelle der Störung ist.

14. Verfahren nach Anspruch 13, wobei Ermitteln der Stelle der Störung in den Wicklungen weiter Ermitteln beinhaltet, welche einer Vielzahl von Windungen von einer oder mehreren der Wicklungen die Stelle der Störung ist.

**Revendications**

1. Appareil pour localiser un défaut dans une pluralité d'enroulements d'un transformateur (20), l'appareil comprenant :

un dispositif de mesure configuré pour mesurer des paramètres de flux électrique du transformateur (20) lorsque le transformateur (20) est dans un mode en ligne ; et
une unité de détermination d'emplacement de défaut (22) configurée pour déterminer des paramètres de flux électrique des enroulements à partir des paramètres de flux électrique mesurés du transformateur (20), dans lequel l'unité de détermination d'emplacement de défaut (22) est configurée pour traiter les paramètres de flux électrique déterminés des enroulements afin de déterminer l'emplacement du défaut dans les enroulements, **caractérisé en ce que** l'unité de détermination d'emplacement de défaut (22) est configurée pour :

déterminer des valeurs de tension de comparaison de phases et des valeurs de courant de comparaison de phases en comparant les paramètres de flux électrique déterminés des enroulements ;
déterminer des valeurs de tension d'excitation des enroulements à partir des valeurs de tension de comparaison de phases et des valeurs de courant de comparaison de phases déterminées ;
déterminer des valeurs de tension d'excitation de comparaison d'enroulements en comparant les valeurs de tension d'excitation déterminées des enroulements ; et
comparer les valeurs de tension d'excitation de comparaison d'enroulements déterminées afin de déterminer celui des enroulements qui est l'emplacement du défaut.

2. Appareil selon la revendication 1, dans lequel la détermination de l'emplacement du défaut dans les enroulements inclut une détermination de celui des enroulements qui est l'emplacement du défaut.

3. Appareil selon la revendication 2, dans lequel la détermination de l'emplacement du défaut dans les enroulements inclut en outre une détermination de celle d'une pluralité de spires d'un ou plusieurs des enroulements qui est l'emplacement du défaut.

4. Appareil selon l'une quelconque des revendications précédentes, dans lequel l'appareil est configuré pour localiser un défaut dans une pluralité d'enroulements d'un transformateur polyphasé (20), l'unité de détermination d'emplacement de défaut (22) est configurée pour déterminer des valeurs de phaseur électrique à partir des paramètres de flux électrique mesurés du transformateur (20), et l'unité de détermination d'emplacement de défaut (22) est configurée pour déterminer les paramètres de flux électrique des enroulements à partir des valeurs de phaseur électrique déterminées.

5. Appareil selon l'une quelconque des revendications précédentes, dans lequel l'unité de détermination d'emplacement de défaut (22) est configurée pour déterminer une ou plusieurs valeurs de courant homopolaire à partir des paramètres de flux électrique déterminés des enroulements, et l'unité de détermination d'emplacement de défaut (22) est configurée pour comparer la ou chaque valeur de courant homopolaire à une ou plusieurs valeurs de courant neutre des enroulements afin de déterminer celui des enroulements qui est l'emplacement du défaut.

6. Appareil selon l'une quelconque des revendications précédentes, dans lequel l'appareil est configuré pour localiser un défaut dans une pluralité d'enroulements d'un transformateur polyphasé (20), et l'unité de détermination d'emplacement de défaut (22) est configurée pour déterminer l'emplacement du défaut sur la base d'un circuit équivalent du transformateur polyphasé (20) qui représente des conditions de tension et de courant dans les enroulements, des impédances des enroulements, une impédance de magnétisation de transformateur et un défaut phase-terre sur un ou plusieurs des enroulements, dans lequel l'unité de détermination d'emplacement de défaut (22) est configurée pour déterminer les conditions de tension et de courant à partir des paramètres de flux électrique déterminés des enroulements.

7. Appareil selon l'une quelconque des revendications précédentes, dans lequel l'appareil est configuré pour localiser un défaut dans une pluralité d'enroulements d'un transformateur polyphasé (20), et l'unité de détermination d'emplacement de défaut (22) est configurée pour déterminer l'emplacement du défaut sur la base d'un circuit équivalent du transformateur polyphasé (20) qui représente des conditions de tension et de courant dans les enroulements, des impédances des enroulements, une impédance de magnétisation de transformateur et un défaut de phase à phase sur un ou plusieurs des enroulements, dans lequel l'unité de détermination d'emplacement de défaut (22) est configurée pour déterminer les conditions de tension et de courant à partir des paramètres de flux électrique déterminés des enroulements.

8. Appareil selon la revendication 7 ou la revendication 8, dans lequel le circuit équivalent du transformateur polyphasé (20) représente en outre une résistance de fuite de transformateur et/ou une réactance de fuite de transformateur.

9. Appareil selon l'une quelconque des revendications précédentes, dans lequel l'appareil est configuré pour localiser un défaut dans une paire d'enroulements d'un transformateur monophasé (20), et l'unité de détermination d'emplacement de défaut (22) est configurée pour déterminer l'emplacement du défaut sur la base d'un circuit équivalent du transformateur monophasé (20) qui représente les conditions de tension et de courant dans les enroulements, des impédances des enroulements, une impédance de magnétisation de transformateur et un défaut inter-spire sur un ou plusieurs des enroulements, dans lequel l'unité de détermination d'emplacement de défaut (22) est configurée pour déterminer les conditions de tension et de courant à partir des paramètres de flux électrique déterminés des enroulements.

10. Appareil selon l'une quelconque des revendications précédentes, dans lequel l'appareil est configuré pour localiser un défaut dans une paire d'enroulements d'un transformateur monophasé (20), et l'unité de détermination d'emplacement de défaut (22) est configurée pour déterminer l'emplacement du défaut sur la base d'un circuit équivalent du transformateur monophasé (20) qui représente des conditions de tension et de courant dans les enroulements, des impédances des enroulements, une impédance de magnétisation de transformateur, et un défaut d'enroulement à enroulement entre les enroulements, dans lequel l'unité de détermination d'emplacement de défaut (22) est configurée pour déterminer les conditions de tension et de courant à partir des paramètres de flux électrique déterminés des enroulements.

11. Appareil selon l'une quelconque des revendications précédentes, dans lequel l'appareil est configuré pour localiser un défaut dans une paire d'enroulements d'un transformateur monophasé (20), et l'unité de détermination de localisation de défaut (22) est configurée pour déterminer l'emplacement du défaut sur la base d'un circuit équivalent du transformateur monophasé (20) qui représente des conditions de tension et de courant dans les enroulements, des impédances des enroulements, une impédance de magnétisation de transformateur, et un défaut d'un enroulement à la terre dans un ou plusieurs des enroulements, dans lequel l'unité de détermination de localisation de défaut (22) est configurée pour déterminer les conditions de tension et de courant à partir des paramètres de flux électrique déterminés des enroulements.

12. Procédé de localisation d'un défaut dans une pluralité d'enroulements d'un transformateur (20), le procédé comprenant les étapes consistant à :

mesurer des paramètres de flux électrique du transformateur (20) lorsque le transformateur (20) est dans un mode en ligne ;
déterminer des paramètres de flux électrique des enroulements à partir des paramètres de flux électrique mesurés du transformateur (20) ; et
traiter les paramètres de flux électrique déterminés des enroulements pour déterminer l'emplacement du défaut dans les enroulements,
le procédé étant en outre **caractérisé par** les étapes consistant à :

- déterminer des valeurs de tension de comparaison de phases et des valeurs de courant de comparaison de phases en comparant les paramètres de flux électrique déterminés des enroulements ;
- déterminer des valeurs de tension d'excitation des enroulements à partir des valeurs de tension de comparaison de phases et des valeurs de courant de comparaison de phases déterminées ;
- déterminer des valeurs de tension d'excitation de comparaison d'enroulements en comparant les valeurs de tension d'excitation déterminées des enroulements ; et
- comparer les valeurs de tension d'excitation de comparaison d'enroulements déterminées afin de déterminer celui des enroulements qui est l'emplacement du défaut.

13. Procédé selon la revendication 12, dans lequel la détermination de l'emplacement du défaut dans les enroulements inclut une détermination de celui des enroulements qui est l'emplacement du défaut.

14. Procédé selon la revendication 13, dans lequel la détermination de l'emplacement du défaut dans les enroulements inclut en outre une détermination de celle d'une pluralité de spires d'un ou plusieurs des enroulements qui est l'emplacement du défaut.

**Figure 1**

**Figure 2**

$i_1^{a*}, i_1^{b*}, i_1^{c*}$

$i_2^{a*}, i_2^{b*}, i_2^{c*}$

$i^{N*}$

Case 1

Faulty winding
detection of two-
winding transformer

$N_W$

FP

$R_T, X_T$

MUX

FW

$\dot{V}_1^{a*}, \dot{V}_1^{b*}, \dot{V}_1^{c*}$
$I_1^{a*}, I_1^{b*}, I_1^{c*}$
$\dot{V}_2^{a*}, \dot{V}_2^{b*}, \dot{V}_2^{c*}$
$i_2^{a*}, i_2^{b*}, i_2^{c*}$
$\dot{V}_3^{a*}, \dot{V}_3^{b*}, \dot{V}_3^{c*}$
$i_3^{a*}, i_3^{b*}, i_3^{c*}$

Faulty winding
detection of multi-
winding transformer

Case 2

**Figure 3**

$i_1^{a*}, i_1^{b*}, i_1^{c*}$

Calculation of
$3i_1^{0*}, 3i_2^{0*}$

$i_2^{a*}, i_2^{b*}, i_2^{c*}$

STEP 2.1.1

$i_1^N, i_2^N$

Comparison of
$3i^{0*}$ and $i^{N*}$

FW

STEP 2.1.2

**Figure 4**

$i^{A*}$

A

$i^{B*}$

B

$i^{C*}$

$i^{N*}$

a

b

c

**Figure 5**

**Figure 6**

**Figure 7**

Figure 8

Figure 9

20

**Figure 10**

**Figure 11**

20

**Figure 12**

**Figure 13**

**Figure 14**

**Figure 15**

## REFERENCES CITED IN THE DESCRIPTION

**Patent documents cited in the description**

- US 2008300807 A1